# EUROPÄISCHE PATENTSCHRIFT

(11) **EP 2 165 580 B1**
(45) Veröffentlichungstag und Bekanntmachung des Hinweises auf die Patenterteilung: **28.10.2015**
(21) Anmeldenummer: 08734443.8
(22) Anmeldetag: 27.03.2008
(51) Int. Cl.: H05K 1/00, H05K 3/00, E05B 17/22, H05K 5/00, E05B 81/54

(54) **SCHLIESSSYSTEM FÜR FAHRZEUGE UND VERWENDUNG EINES KOMPONENTENTRÄGERS**
LOCKING SYSTEMS FOR VEHICLES AND USE OF A CARRIER FOR COMPONENTS
SYSTEMES DE FERMETURE POUR VEHICULES ET UTILISATION DE SUPPORT POUR COMPOSANTS

(30) Priorität: 05.04.2007 DE 202007005076 U
(43) Veröffentlichungstag der Anmeldung: 24.03.2010
(73) Patentinhaber: Kiekert Aktiengesellschaft, 42579 Heiligenhaus (DE)
(72) Erfinder: JOKIEL, Christian, 42579 Heiligenhaus (DE); GRAUTE, Ludger, 45130 Essen (DE)
(74) Vertreter: Schwabe - Sandmair - Marx
(86) Internationale Anmeldenummer: PCT/DE2008/000514
(87) Internationale Veröffentlichungsnummer: WO 2008/122262

(56) Entgegenhaltungen:
- EP-A- 0 827 372
- EP-A- 1 231 824
- WO-A1-2005/032223
- DE-A1- 19 817 198
- DE-C1- 19 955 603
- GB-A- 2 061 623

## Beschreibung

Die vorliegende Erfindung betrifft ein Schließsystem mit einem Komponententräger, der einen ersten und wenigstens einen zweiten Abschnitt aufweist. Darüber hinaus betrifft die Erfindung eine Verwendung eines Komponententrägers bei der Herstellung eines Schließsystems für Fahrzeuge. Die Erfindung findet insbesondere Anwendung im Automobil-Bereich.

Ein üblicher Aufbau eines Komponententrägers geht beispielsweise aus der EP 1 231 824 A2 hervor. Dort wird eine Leiterbahneinheit beschrieben, die mit elektrischen bzw. elektronischen Bauteilen bzw. Komponenten bestückt werden kann. Beispiele für solche Bauteile sind Stecker, Mikroschalter, Sensoren, Motoren usw., die in einer Türschlosseinheit eines Kraftfahrzeuges zum Einsatz kommen. Die Leiterbahneinheit besteht dabei im Wesentlichen aus einer flexiblen Leiterbahnfolie, welche von zwei Versteifungselementen zu einem Modul aus Kunststoff umspritzt ist. Für die Anbringung der angeführten Bauteile kann das Modul noch mit einer gesonderten Aufnahme im Rahmen des Umspritzens versehen werden. Mit einer solchen Leiterbahneinheit wurde es bei Kraftfahrzeugtürschlössern möglich, einen relativ steifen bzw. formstabilen Komponententräger bereit zustellen, mit dem eine sichere Positionierung der Bauteile bzgl. des Kraftfahrzeugschlosses gewährleistet werden kann.

Im Hinblick auf die vielfach unterschiedliche Ausgestaltung solcher Kraftfahrzeugtürschlösser, insbesondere mit Bezug auf die unterschiedlichen Ausführungsvarianten bei elektrisch öffnenden Schlössern, Türschlössern mit Zentralverriegelung, Türschlössern mit Personenidentifikationseinheit, Türschlössern mit Kinder- und/oder Diebstahlssicherung, Schlösser mit Zuziehhilfen und dergleichen, sind die Komponententräger regelmäßig mit unterschiedlichen Bauteilen zu bestücken, und entsprechende elektrische Verbindungen bereitzustellen. Auch wenn es sich bei dem Komponententräger um ein relativ kostengünstiges herstellbares Bauteil handelt, so ist doch bei der angedeuteten Variantenvielfalt ein beachtlicher Aufwand bezüglich der Logistik und der Lagerung erforderlich.

Hiervon ausgehend ist es eine Aufgabe der vorliegenden Erfindung, die mit Bezug auf den Stand der Technik geschilderten Probleme zumindest teilweise zu lösen. Insbesondere soll ein Schließsystem mit einem Komponententräger angegeben werden, der bei einer möglichst großen Anzahl von Varianten einsetzbar ist. Dadurch sollen die mit der Herstellung eines Komponententrägers verbundenen Kosten reduziert und der logistischen Aufwand gemindert werden.

Diese Aufgabe wird mit einer Vorrichtung gemäß den Merkmalen des Schutzanspruchs 1 gelöst. Ebenfalls gelöst wird diese Aufgabe durch die Verwendung gemäß dem Schutzanspruch 9.

Die in den Schutzansprüchen angegebenen Merkmale werden in der Beschreibung näher präzisiert und erläutert, wobei weitere bevorzugte Ausführungsbeispiele der Erfindung dargestellt werden.

Der Komponententräger in dem erfindungsgemäßen Schließsystem ist einteilig und weist einen ersten Abschnitt und wenigstens einen zweiten Abschnitt auf, wobei zwischen beiden Abschnitten eine labile linienförmige Verbindung vorgesehen und als Sollbruchstelle ausgebildet ist.

Mit dieser Beschreibung ist insbesondere ein Halbzeug für einen Elektrokomponententräger angegeben, der einteilig hergestellt und für eine Vielzahl von Anwendungen eingesetzt werden kann. "Einteilig" heißt in diesem Zusammenhang insbesondere, dass eine stoffliche Verbindung und bezüglich des Komponententrägers im Wesentlichen gleiche Materialzusammensetzungen in allen Abschnitten vorliegen. Folglich weisen alle Abschnitte und die Verbindung (wenigstens ein gemeinsames) Material auf.

Der erste Abschnitt ist dabei beispielsweise ein (größerer und/oder massiverer) Hauptträger eines Elektrokomponententrägers. Der Elektrokomponententräger ist zur Aufnahme von Komponenten ausgebildet, wie sie in einem Schließsystem, insbesondere in einem Fahrzeugschließsystem, Verwendung finden. Der Hauptträger ist dabei zur Aufnahme einer Mehrzahl von Komponenten oder zur Aufnahme von besonders wichtigen Komponenten ausgebildet. Der zweite Abschnitt kann beispielsweise von einem (kleineren und/oder filigraneren) Nebenträger gebildet werden, welcher zur Aufnahme einer oder mehrer weiterer Komponenten ausgebildet ist, die in einer späteren Einbaulage satellitenähnlich in der Nachbarschaft (um den Hauptträger herum) angeordnet verbaut werden können.

Aufgrund der Bereitstellung der labilen linienförmigen Verbindung zwischen den Abschnitten des Komponententrägers ist es nun möglich, den Komponententräger mit beiden Abschnitten, sowohl dem ersten als auch dem zweiten, als einteiliges Werkstück herzustellen. Der "labile" Bereich weist insbesondere ein gegenüber den Abschnitten anderes Verformungsverhalten auf und/oder weist eine abweichende Strukturfestigkeit auf. Damit wird nun ermöglicht, dass die Relativlage der Abschnitte zueinander verändert werden kann, wobei die "linienförmige" Ausgestaltung der Verbindung in einfacher Weise eine fortlaufende Grenze zwischen den Abschnitten darstellt. Wird demnach der labile Verbindungsbereich betätigt, z.B. in dem die Abschnitte zueinander bewegt, verschwenkt, etc. werden, kann eine andendungsspezifische Ausrichtung der Abschnitte zueinander oder im Hinblick auf das Schließsystem vorgenommen werden.

Beide Abschnitte in einem einzigen Verfahrensschritt und mit einem Werkzeug zu fertigen senkt die Kosten, da beide Abschnitte zusammen gefertigt werden können. Eine Fertigungsmaschine kann somit pro Zeiteinheit zwei und mehr Abschnitte fertigen, was gegenüber einer Einzelfertigung deutliche Kostenvorteile mit sich bringt.

Ein weiterer Vorteil der Erfindung besteht darin, dass der Komponententräger in einem nachfolgenden Fertigungsverfahren zur Herstellung eines Schließsystems zunächst als einteiliges Bauteil handhabbar ist. Es ist somit keine Vielzahl von unterschiedlichen Abschnitten sondern nur ein einziges Bauteil im Rahmen der Logistik zu handhaben. Hierdurch reduziert sich der Logistikaufwand erheblich. Außerdem können die verschiedenen Abschnitte zunächst nicht verloren gehen, da sie miteinander verbunden sind.

Bei einer anderen besonders bevorzugten Ausführungsform der Erfindung ist vorgesehen, dass zumindest ein Abschnitt des Komponententrägers aus wenigstens zwei unterschiedlichen Werkstoffen gefertigt ist, von denen wenigstens ein Werkstoff elektrisch leitend ist. Als nichtleitende Werkstoffe kommen beispielsweise Kunststoffe und/oder Elastomere in Betracht. Als elektrisch leitende Werkstoffe können Metalle wie beispielsweise Kupfer oder Kupferlegierungen sowie andere Metalllegierungen verwendet werden. Durch die Kombination aus einem leitenden und einem weiteren Werkstoff ist es möglich, elektrisch leitende Kontaktstränge durch die Abschnitte des Komponententrägers hindurch herzustellen. Diese elektrisch leitenden Kontaktstränge können später zum elektrischen Anschluss der auf dem Komponententräger montierten Komponenten genutzt werden.

Der Komponententräger ist erfindungsgemäß mit einer labile linienförmige Verbindung ausstattet, die als Sollbruchstelle ausgebildet ist. Eine solche Sollbruchstelle kann beispielsweise in

Form wenigstens eines dünnen Steges ausgebildet sein (bevorzugt ist die Bereitstellung einer Vielzahl von Stegen entlang der linienförmigen Verbindung), welcher die Abschnitte des Komponententrägers miteinander verbindet. Beim Aufbringen einer entsprechenden Kraft, steigt die Spannungsbeanspruchung in diesen dünnen Stegen, aufgrund eines stark verringerten Wirkungsquerschnitts sehr stark an und die Stege brechen. Die Abschnitte sind dadurch leicht voneinander trennbar. Die kann im einfachsten Fall rein manuell geschehen.

Für eine besonders kostengünstige Fertigung ist es vorteilhaft, wenn der Kompönententräger aus einem Werkstoff gefertigt ist, der ein Kunststoff ist. Hierzu stehen beispielsweise Kunststoffe wie PBT, POM, PA, PP, PE, ABS, ABS-PC und deren unterschiedlichste Varianten, wie beispielsweise solche mit Glasfaserverstärkungen oder Talkumverstärkungen, zur Verfügung. Aber auch sehr preiswerte Kunststoffe wie Recyclate können zur Herstellung eines erfindungsgemäßen Komponententrägers eingesetzt werden.

Besonders einfach kann ein Komponententräger gefertigt werden, wenn der leitende Werkstoff von dem zweiten verwendeten Werkstoff zumindest teilweise umschlossen ist. Damit ist es möglich den leitenden Werkstoff in einem ersten Fertigungsverfahren bzw. in einem ersten Fertigungsschritt etwa aus einer Kupferplatine mittels Stanzen zu fertigen, um ihn danach mit einem Kunststoff isolierend zu umschließen. Dies geschieht vorzugsweise nur teilweise, um einen späteren Anschluss des leitenden Werkstoffes in diesen Bereichen an Stecker oder Leitungen zu erleichtern.

Besonders günstig ist es dazu, wenn der Abschnitt mit dem leitenden Werkstoff elektrische Anschlusseinrichtungen aufweist. Dazu können beispielsweise die nicht umschlossenen Abschnitte des leitenden Werkstoffes als Stecker ausgebildet sein. Die Stecker können wahlweise so genannte männliche oder weibliche Steckerabschnitte sein, welche zum Anschluss von Kabeln oder elektrischen Komponenten geeignet sind. Hierzu sind sämtliche geeigneten und zahlreich bekannten Steckerverbindungen einsetzbar, insbesondere solche, die bereits im Automobilbereich Anwendung finden.

Besonders kostengünstig ist ein Komponententräger zu fertigen, wenn zumindest ein Abschnitt mehrfach oder spiegelsymmetrisch daran ausgebildet ist. So kann beispielsweise ein Hauptträger, welcher einen ersten Abschnitt darstellt, einfach

ausgebildet sein und ein dazugehöriger Nebenträger, welcher einen zweiten, dritten usw. Abschnitt darstellt, mehrfach vorgesehen sein. Zwischen jedem der Nebenträger und dem Hauptträger ist dabei zunächst eine labile linienförmige Verbindung vorgesehen. Benötigt man etwa für ein Fahrzeug einen Komponententräger in unterschiedlicher Konfiguration, das heißt beispielsweise mit zwei, drei oder vier Nebenträgern (zweiten Abschnitten), so kann man den Komponententräger zunächst mit vier daran ausgebildeten Nebenträgern fertigen. Benötigt man nun eine Konfiguration mit vier Nebenträgern, so können diese entsprechend bestückt und verbaut werden. Benötigt man aber eine Konfiguration mit drei Nebenträgern, so wird ein überzähliger Neberiträger entfernt und die verbleibenden Abschnitte werden entsprechend konfiguriert. Entsprechendes gilt dann für eine Konfiguration mit zwei Nebenträgern, wobei zwei Nebenträger zu entfernen sind. An dem beschriebenen Beispiel ist gut erkennbar, dass mit nur einem einzigen Komponententräger drei unterschiedliche Konfigurationen in der Fertigung abgedeckt werden können.

Einen noch größeren Vorteil, d.h. eine noch günstigere und einfachere Fertigung erreicht man, indem Abschnitte daran auch spiegelsymmetrisch ausgebildet sind. Hierdurch ist es dann beispielsweise möglich in einem einzigen Arbeitsschritt Komponententräger, sowohl für eine linke Fahrzeugseite, als auch für eine rechte Fahrzeugseite zu fertigen, da diese häufig spiegelsymmetrisch ausgebildet sind.

Als besonders kostengünstig hat es sich im Rahmen der Erfindung erwiesen, wenn zumindest ein Abschnitt als Kunststoffspritzgußteil mit eingelegten Leitungen bzw. Leiterbahnen ausgebildet ist. Hierbei dient der Kunststoff als isolierender Werkstoff und die eingelegten Leiterbahnen, die beispielsweise aus Kupferplatinen gestanzt sind, können in einem preisgünstigen Verfahren mit Kunststoff umspritzt werden. Dieses Verfahren ist besonders für hohe Stückzahlen geeignet.

Für den Einsatz in Schließsystemen ist es zudem vorteilhaft, wenn der Komponententräger zur Aufnahme von Komponenten, insbesondere von Elektromotoren und/oder Mikroschaltern ausgebildet ist. Diese Komponenten sind sehr häufig verwendete Komponenten und müssen oft in unterschiedlichen Konfigurationen bereitgestellt werden.

Eine Trägereinrichtung umfasst einen Komponententräger, wobei die Abschnitte zumindest teilweise mit Komponenten bestückt und diese Komponenten elektrisch leitend angebunden sind.

Eine solche bestückte Trägereinrichtung kann im konfektionierten Zustand als eigenständiges Modul gehandhabt werden oder in einem Kraftfahrzeug befestigt sein. Die Komponenten sind dabei über Leitungen, wie beispielsweise Kabelverbindungen elektrisch leitend an andere Komponenten oder an den leitenden Werkstoff zumindest eines Abschnitts angebunden. So können beispielsweise sämtliche Komponenten über Leitungen angebunden werden, die zu einer zentralen Stelle zusammenlaufen und dort über eine Steckereinrichtung zusammengefasst sind. An einer solchen zentralen Steckereinrichtung ist es dann möglich den gesamten Komponententräger zentral an das Fahrzeug anzuschließen.

Für eine einfache und sichere Montage hat es sich zudem bewährt, wenn die Trägereinrichtung zwischen wenigstens zwei Abschnitten Sicherungsmittel aufweist. Diese Sicherungsmittel können beispielsweise durch Kabelbinder, Schlaufen, Klammern oder ähnliche bekannte Mittel ausgebildet sein, welche bis zu einer endgültigen Montage bzw. bis zum Erreichen einer gesicherten Stellung temporär an der Trägereinrichtung verbleiben. In diesem Zustand ist die Trägereinrichtung dann problemlos transportierbar.

Schließlich ist das Schließsystem für Fahrzeug auf das sich die Erfindung bezieht, mit einer Trägereinrichtung ausgestattet, wie sie in der zuvor beschriebenen Weise ausgebildet ist.

Zur Verwirklichung der Erfindung kommt auch eine Verwendung eines Komponententrägers gemäß Anspruch 9.

Im Weiteren werden die Abschnitte zumindest teilweise voneinander getrennt, mit Komponenten bestückt und über Leitungen miteinander verbunden. Diese Schritte können je nach Situation in beliebiger Reihenfolge nacheinander ausgeführt werden.

Schließlich können die voneinander getrennten Abschnitte noch durch Sicherungsmittel zumindest temporär miteinander verbunden werden, um die Abschnitte beispielsweise bei einem Transport gegen Verlust zu sichern.

Der Herstellungsschritt des Komponententrägers kann beispielsweise durch das zuvor beschriebene Umspritzen von metallischen Einlegeteilen mit Kunststoff geschehen.

Dabei wird zunächst ein Einlegeteil aus einem ersten Werkstoff, beispielsweise aus einem elektrisch leitenden Werkstoff wie einer Kupferlegierung, gefertigt und danach in einem weiteren Schritt mit einem weiteren Werkstoff, wie beispielsweise einem Kunststoff, umspritzt zu werden.

Weitere Vorteile der durch die Patentansprüche definierten Erfindung sind im Zusammenhang mit den nachfolgenden Ausführungsbeispielen und der Zeichnung beschrieben. Es zeigt darin:
Fig. 1: einen Komponententräger nach dem Stand der Technik;
Fig. 2: einen Komponententräger in einer Draufsicht;
Fig. 3: Komponenten und Leitungen des Komponententrägers nach Fig. 2;
Fig. 4: den Komponententräger nach Fig. 3 in einem konfigurierten Zustand; und
Fig. 5: einen weiteren Komponententräger in einer Draufsicht.

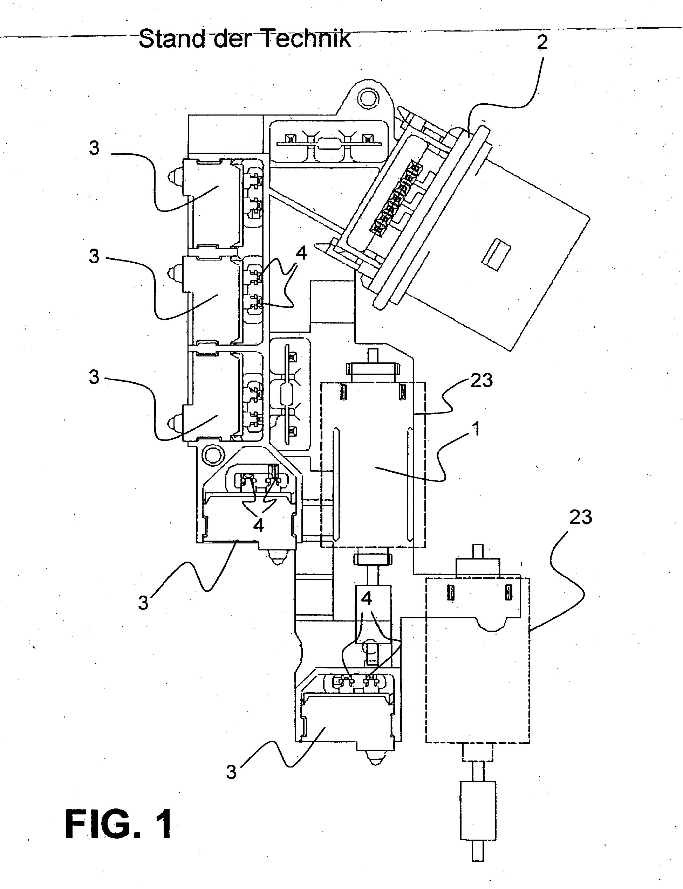

In Fig. 1 ist ein Komponententräger 1 nach dem Stand der Technik in einer Draufsicht dargestellt. Der Komponententräger 1 weist eine längliche Form auf, wobei sich an seinem oberen Ende eine Steckereinrichtung 2 befindet. Auf dem Komponententräger 1 sind fünf Mikroschalter 3 angeordnet. Die Mikroschalter 3 sind über elektrische Leitungen 4 mit der Steckereinrichtung 2 verbunden. Weiterhin ist durch strichpunktierte Linien ein Elektromotor 23 in zwei verschiedenen Einbausituationen dargestellt, mit dem der Komponententräger 1 bestückt ist.

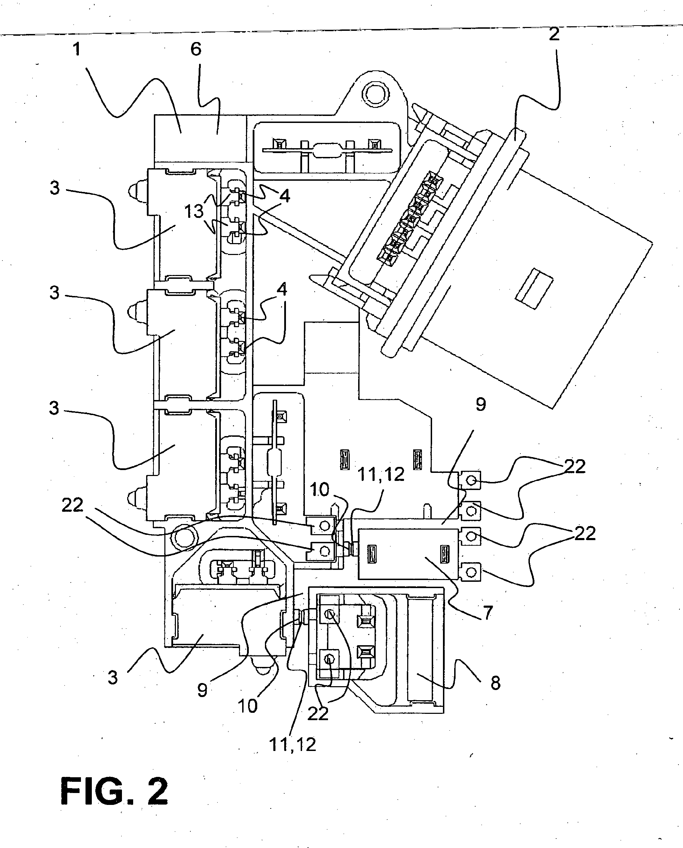

In Fig. 2 ist eine erfindungsgemäße Trägereinrichtung 5 dargestellt, welche aus dem Komponententräger 1 sowie den darauf angeordneten Komponenten in Form der Mikroschalter 3 besteht. Der Komponententräger 1 weist einen ersten Abschnitt 6 auf, der einen Hauptträger bildet. An dem ersten Abschnitt 6 sind im unteren Bereich zwei weitere Abschnitte angeformt. Es handelt sich dabei um einen zweiten Abschnitt 7 sowie einen dritten Abschnitt 8. Zwischen dem jeweiligen Abschnitt 7 bzw. 8 und dem Abschnitt 6 ist eine labile linienförmige Verbindung 9 angeordnet. Bei beiden Abschnitten 7 und 8 ist die linienförmige Verbindung 9 annähernd L-förmig ausgebildet und beschreibt im Wesentlichen eine Kantenprojektion der aneinander angrenzenden Flächen der Abschnitte 6, 7 bzw. 6,8. Diese Kantenprojektionen verlaufen bei beiden Abschnitten 7 und 8 in etwa parallel zu dem zwischen ihnen und dem Abschnitt 6 liegenden Spalt. An einer Stelle der linienförmigen Verbindungen 9 befindet sich jeweils ein Steg 10 mit einer Einschnürung 11. Dabei handelt es sich um eine Sollbruchstelle 12. Die durch den Steg 10 mit der Einschnürung 11 ausgebildete Sollbruchstelle 12 ist so ausgelegt, dass eine sichere Verbindung der Abschnitte 7 und 8 mit dem Abschnitt 6 gewährleistet ist. Sie ist aber gleichzeitig im Bereich der Einschnürung 11 in ihrem wirksamen Querschnitt soweit reduziert, dass die Abschnitte 7, 8 manuell vom Abschnitt 6 abtrennbar sind. Zur elektrischen Anbindung der Komponenten und insbesondere der Mikroschalter 3 an die Steckereinrichtung 2 sind Kontaktstellen 22 vorgesehen. Diese sind an den Endender teilweise umschlossenen Leitungen 4 vorgesehen, wo sie, als Stecker 13 ausgebildet die Mikroschalter 3 elektrisch anbinden. Im Bereich der Abschnitte 1 und 2 sind die Kontaktstellen 22 als Lötverbindungen ausgebildet.

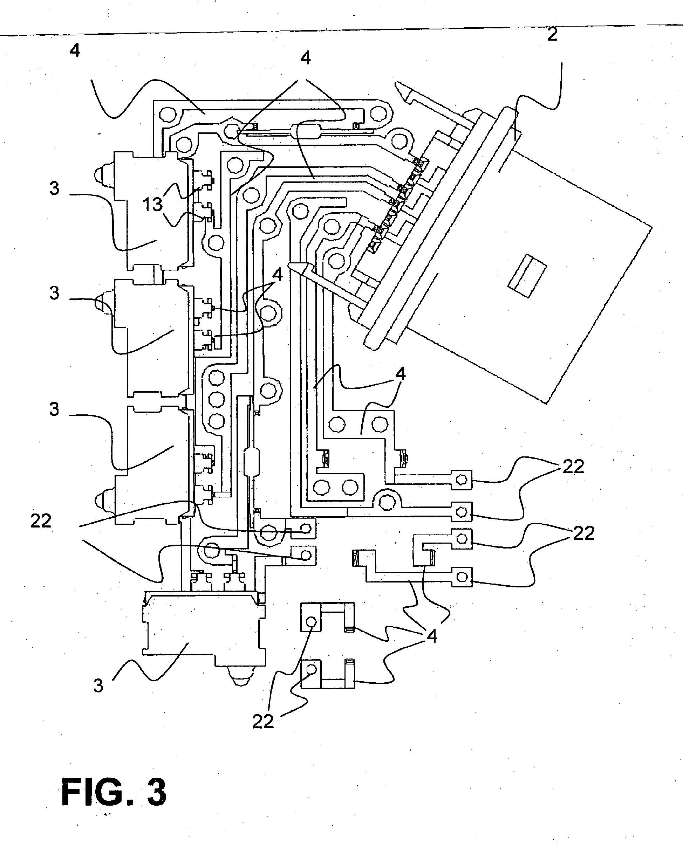

In Fig. 3 ist der Komponententräger 1 nach Fig. 2 in derselben Ansicht gezeigt, wobei von den Abschnitten 6,7 und 8 nur die elektrisch leitenden Werkstoffkomponenten dargestellt ist. Die in Fig. 3 dargestellte Werkstoffkomponente zeigt den elektrisch leitenden Werkstoff, aus welchem die Leitungen 4 gebildet sind. Besonders deutlich erkennbar sind dabei wiederum die Kontaktstellen 22, die sich an den Enden der jeweiligen Leitungen 4 befinden.

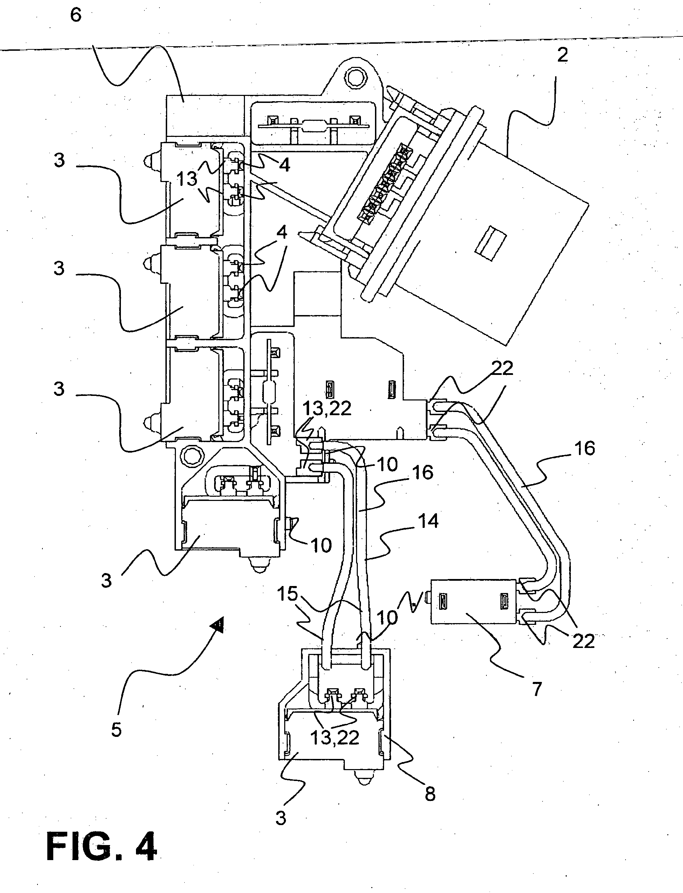

In Fig. 4 ist die erfindungsgemäße Trägereinrichtung 5 in einem konfektionierten Zustand dargestellt. Die Abschnitte 7 und 8 sind dabei an den Stegen 10 jeweils vom ersten Abschnitt 6 abgetrennt worden. Weiterhin ist erkennbar, dass nun die Abschnitte 6 und 8 mit Mikroschaltern 3 bestückt sind. Um nun den Mikroschalter 3, der auf dem Abschnitt 8 positioniert ist, mit den Leitungen 4 und den daran befindlichen Kontaktstellen 22 zu verbinden, ist eine aus zwei annähernd parallel geführten Leitungskanälen 15 bestehende Kabelleitung 14 vorgesehen, welche an die jeweiligen Stecker 13 des Abschnitts 8 und des Abschnitts 6 elektrisch leitend angeschlossen ist. In ähnlicher Weise sind auch die Kontaktstellen 22 des Abschnitts 7 mit den ihnen zugeordneten Steckern 13 des Abschnitts 6 über eine weitere Kabelleitung 14 verbunden. Bei der gezeigten Ausführungsform haben die Kabelleitungen 14 neben der Funktion der elektrischen Anbindung der Abschnitte 7 und 8 noch die Funktion eines Sicherungsmittels 16. Durch die Kabelleitungen 14 werden die Abschnitte 7 und 8 solange gegen ein Verlieren gesichert, bis die Trägereinrichtung 5 sich in ihrer endgültigen oder einer gesicherten Einbaulage befindet.

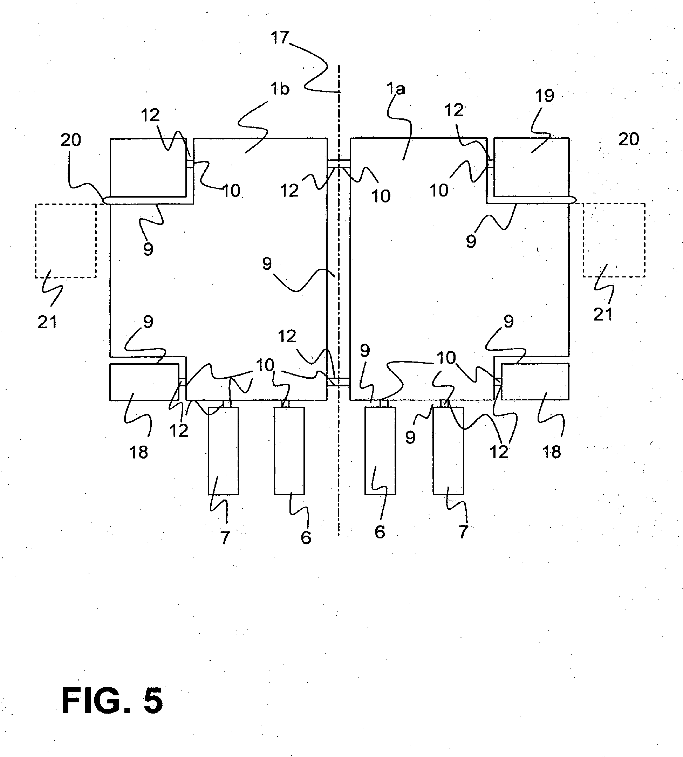

In Fig. 5 ist schließlich eine andere Ausführungsform in einer Draufsicht dargestellt. Die dort gezeigten Komponententräger 1a und 1b sind in Bezug auf eine Mittelachse 17 spiegelsymmetrisch aufgebaut. D. h. in einem ersten Herstellungsschritt kann ein Bauteil mit den Kornponententräger 1a und 1b hergestellt werden, das sämtliche benötigten Abschnitte für einen Verbau in einer linken und einer rechten Fahrzeugseite umfasst. Im Bereich der Längsachse 17 ist die labile linienförmige Verbindung 9 entlang der Längsachse 17 ausgebildet. Als Sollbruchstelle 12 ist zwischen der linken Hälfte und der rechten Hälfte wiederum die Anordnung von zwei Stegen 10 vorgesehen. Zum Trennen der Trägereinrichtung 1a von der Trägereinrichtung 1b sind die Stege 10 vorzugsweise so ausgelegt, dass sie manuell und ohne Zuhilfenahme von Werkzeugen trennbar sind, ansonsten jedoch einen sicheren Zusammenhalt der Abschnitte gewährleisten. An der Unterseite jedes Komponententrägers 1a und 1b befinden sich zwei Abschnitt 6 und 7, die jeweils über Stege 10 angebunden sind. Die Stege 10 sind auch an dieser Stelle wieder als Sollbruchstellen 12 ausgebildet. Die Besonderheit der hier dargestellten Abschnitte 6 und 7 liegt darin, dass sie identisch sind. Werden bei einer bestimmten Konfiguration pro Seite zwei gleiche Abschnitte benötigt, so werden beide Abschnitte 6 und 7 verwendet. Wird bei einer anderen Konfiguration lediglich ein einzelner Abschnitt 6 oder 7 benötigt, so kann einer der beiden Abschnitte 6 oder 7 abgetrennt und einer Wiederverwendung zugeführt werden.

Im Weiteren weisen die Komponententräger 1a und 1b noch die Abschnitte 18 und 19 auf, welche anders als die Abschnitte 6 und 7 ausgebildet sind. Während der Abschnitt 18 wiederum über einen als Sollbruchstelle 12 ausgebildeten Steg 10 an den Komponententräger 1a bzw. 1b angebunden ist, wird der Abschnitt 19 an zwei Stellen am jeweiligen Komponententräger 1a bzw. 1b gehalten. Während die L-förmige Verbindung 9 im oberen Bereich des Abschnitts 19 einen als Sollbruchstelle 12 ausgebildeten Steg 10 aufweist, ist im unteren Bereich ein Filmscharnier 20 zur dauerhaften Anbindung des Abschnitts 19 an den Komponententräger 1a bzw. 1b vorgesehen. Bei einer Konfiguration bzw. einem Einbau kann die Verbindung 9 an der Sollbruchstelle 12 gelöst und der Abschnitt 19 in die gestrichelt dargestellte Einbaulage 21 verschwenkt werden. Insgesamt ist somit ein ein Bauteil mit zwei Komponententrägern 1a und 1b geschaffen worden, welches in besonders einfacher Weise, nämlich insbesondere durch Kunststoffumspritzung von metallischen Leiterbahnen, herstellbar ist. Darüber hinaus ist der erfindungsgemäße mehrfache Komponententräger 1a, 1b in besonders einfacher Weise an eine Vielzahl von Konfigurationsmöglichkeiten anzupassen. Es ist jedoch aus möglich, mehrere gegebenenfalls gleiche Komponententräger 1a, 1b in einem Arbeitsgang herzustellen.

Die vorliegende Erfindung ist nicht auf die dargestellten Ausführungsbeispiele beschränkt. Es sind vielmehr zahlreiche Abwandlungen der Erfindung im Rahmen der Schutzansprüche möglich. So können beispielsweise anstelle der beschriebenen Materialien andere geeignete Werkstoffe zum Einsatz kommen. Auch kann die Art der Bestückungen, z.B. mit Komponenten anderer Art und Funktion, in nahezu beliebiger Weise variiert werden. Die Erfindung ist nicht auf die beschriebenen Elektromotoren oder Mikroschalter 3 beschränkt.

### Bezugszeichenliste

- 1: Komponententräger
- 2: Steckereinrichtung
- 3: Mikroschalter
- 4: Leitungen
- 5: Trägereinrichtung
- 6: erster Abschnitt
- 7: zweiter Abschnitt
- 8: dritter Abschnitt
- 9: Verbindung
- 10: Steg
- 11: Einschnürung
- 12: Sollbruchstelle
- 13: Stecker
- 14: Kabelleitung
- 15: Leitungskanal
- 16: Sicherungsmittel
- 17: Längsachse
- 18: vierter Abschnitt
- 19: fünfter Abschnitt
- 20: Filmscharnier
- 21: Einbaulage
- 22: Kontaktstelle
- 23: Elektromotor

## Patentansprüche

1. Schließsystem für Fahrzeuge mit einem Komponententräger (1), der einteilig ist und wenigstens einen ersten Abschnitt (6) und einen zweiten Abschnitt (7) aufweist, **dadurch gekennzeichnet, dass** zwischen beiden Abschnitten (6, 7) eine labile linienförmige Verbindung (9) vorgesehen und als Sollbruchstelle (12) ausgebildet ist.

2. Schließsystem nach dem vorhergehenden Anspruch, wobei zumindest ein Abschnitt (6, 7) des Komponententrägers (1) aus wenigstens zwei unterschiedlichen Werkstoffen gefertigt ist, von denen wenigstens ein Werkstoff elektrisch leitend ist.

3. Schließsystem nach einem der vorhergehenden Ansprüche, **dadurch gekennzeichnet, dass** ein Werkstoff ein Kunststoff ist.

4. Schließsystem nach einem der vorhergehenden Ansprüche, **dadurch gekennzeichnet, dass** der leitende Werkstoff von dem zweiten verwendeten Werkstoff zumindest teilweise umschlossen ist.

5. Schließsystem nach einem der vorhergehenden Ansprüche, **dadurch gekennzeichnet, dass** der Abschnitt (6, 7) mit dem leitenden Werkstoff elektrische Anschlusseinrichtungen (22) aufweist.

6. Schließsystem nach einem der vorhergehenden Ansprüche, **dadurch gekennzeichnet, dass** zumindest ein Abschnitt des Komponententrägers (1) als Kunststoffspritzgussteil mit eingelegten Leitungen (4) ausgebildet ist.

7. Schließsystem nach einem der vorhergehenden Ansprüche, **dadurch gekennzeichnet, dass** der Komponententräger (1) zur Aufnahme von Komponenten, insbesondere von Elektromotoren (23) und/oder Mikroschaltern (3) ausgebildet ist.

8. Schließsystem nach einem der vorhergehenden Ansprüche, wobei zwischen wenigstens zwei Abschnitten (6, 7) des Kömponententrägers (1) Sicherungsmittel (16) vorgesehen sind.

9. Verwendung eines Komponententrägers (1), der einteilig ist und wenigstens einen ersten Abschnitt (6) und einen zweiten Abschnitt (7) aufweist, wobei zwischen beiden Abschnitten (6, 7) eine labile linienförmige Verbindung (9) vorgesehen und als Sollbruchstelle (12) ausgebildet ist, bei der Herstellung eines Schließsystems für Fahrzeuge.

## Claims

1. A locking system for vehicles with a component carrier (1), which is a one part unit having at least a first section (6) and a second section (7), **characterized in that** a weak linelike connection (9) is provided between the two sections (6, 7) and designed as a predetermined breaking point (12).

2. The locking system according to the preceding claim, wherein at least one section (6, 7) of the component carrier (1) is produced of at least two different materials, at least one of which is electrically conductive.

3. The locking system according to any one of the preceding claims, **characterized in that** one material is a plastic.

4. The locking system according to any one of the preceding claims, **characterized in that** the conductive material is at least partly surrounded by the second material used.

5. The locking system according to any one of the preceding claims, **characterized in that** the section (6, 7) with the conductive material comprises electric terminals (22).

6. The locking system according to any one of the preceding claims, **characterized in that** at least one section of the component carrier (1) is designed as an injection molded plastic part with inserted conductors (4).

7. The locking system according to any one of the preceding claims, **characterized in that** the component carrier (1) is designed to receive components, in particular electric motors (23) and/or micro switches.

8. The locking system according to any one of the preceding claims, wherein securing means (16) are provided between at least two sections (6, 7) of the component carrier (1).

9. Use of a component carrier (1), which is a one part unit having at least a first section (6) and a second section (7), wherein a weak linelike connection (9) is provided between the two sections (6, 7) and designed as a predetermined breaking point (12), at the manufacture of a locking system for vehicles.

## Revendications

1. Système de fermeture pour véhicules comprenant un support de composants (1), qui est d'une seule pièce et présente au moins un premier tronçon (6) et un deuxième tronçon (7), **caractérisé en ce qu'**entre les deux tronçons (6, 7) est formée une liaison plus fragile (9) en forme de ligne, réalisée en tant que zone de rupture programmée (12).

2. Système de fermeture selon la revendication précédente, dans lequel au moins un tronçon (6, 7) du support de composants (1) est fabriqué en au moins deux matériaux différents, dont au moins un matériau est électriquement conducteur.

3. Système de fermeture selon l'une des revendications précédentes, **caractérisé en ce qu'**un matériau est une matière plastique.

4. Système de fermeture selon l'une des revendications précédentes, **caractérisé en ce que** le matériau conducteur est enfermé au moins partiellement par le deuxième matériau utilisé.

5. Système de fermeture selon l'une des revendications précédentes, **caractérisé en ce que** le tronçon (6, 7) avec le matériau conducteur présente des dispositifs de connexion ou de raccordement électrique (22).

6. Système de fermeture selon l'une des revendications précédentes, **caractérisé en ce qu'**au moins un tronçon du support de composants (1) est réalisé sous forme de pièce en matière plastique moulée par injection, comportant des conducteurs (4) noyés en insertion.

7. Système de fermeture selon l'une des revendications précédentes, **caractérisé en ce que** le support de composants (1) est configuré pour accueillir des composants, notamment des moteurs électriques (23) et/ou des micro-commutateurs (3).

8. Système de fermeture selon l'une des revendications précédentes, dans lequel des moyens de retenue de sécurité (16) sont prévus entre au moins deux tronçons (6, 7) du support de composants (1).

9. Utilisation d'un support de composants (1), qui est d'une seule pièce et présente au moins un premier tronçon (6) et un deuxième tronçon (7), et dans lequel entre les deux tronçons (6, 7) est formée une liaison plus fragile (9) en forme de ligne réalisée en tant que zone de rupture programmée (12), dans le cadre de la fabrication d'un système de fermeture pour véhicules.
